# EUROPEAN PATENT APPLICATION

(11) **EP 1 345 321 A1**
(43) Date of publication of application: **17.09.2003**
(21) Application number: 02251799.9
(22) Date of filing: 13.03.2002
(51) Int. Cl.: H03F 3/21, H03F 3/60, H03F 1/32

(54) **A circuit comprising amplifiers connected in parallel, and a method of reducing the difference in amplitude between output signals from amplifiers thereof**

(71) Applicant: LUCENT TECHNOLOGIES INC., Murray Hill, New Jersey 07974-0636 (US)
(72) Inventor: Cooper, Stephen Edward, Swindon, Wiltshire SN5 5DQ (GB); Jones, Robert, Stonehouse, Gloucestershire GL10 2PJ (GB)
(74) Representative: Sarup, David Alexander

(57) **Abstract**

A circuit is provided comprising at least two amplifiers (20,22,120,122,220,222,320,322) electrically connected in parallel. The circuit includes a controller (38,138,238,338) operative to reduce the difference in amplitude between output signals from the amplifiers. The controller (38,138,238,338) is operative to determine or receive an indicator of the difference in amplitude between the output signal (A) of a first amplifier (20,120,220,320) and the output signal (B) of a second amplifier (22,122,222,322), and to adjust the gain of at least one of the first and second amplifiers dependent upon the indicator.

## Description

### Technical Field

The present invention relates to a circuit comprising at least two amplifiers electrically connected in parallel. The present invention also relates to a method of reducing the difference in amplitude between output signals from amplifiers electrically connected in parallel.

### Background of the Invention

There is usually a tight tolerance placed on the gain and phase of an amplifier; however gain and phase errors cause significant problems.

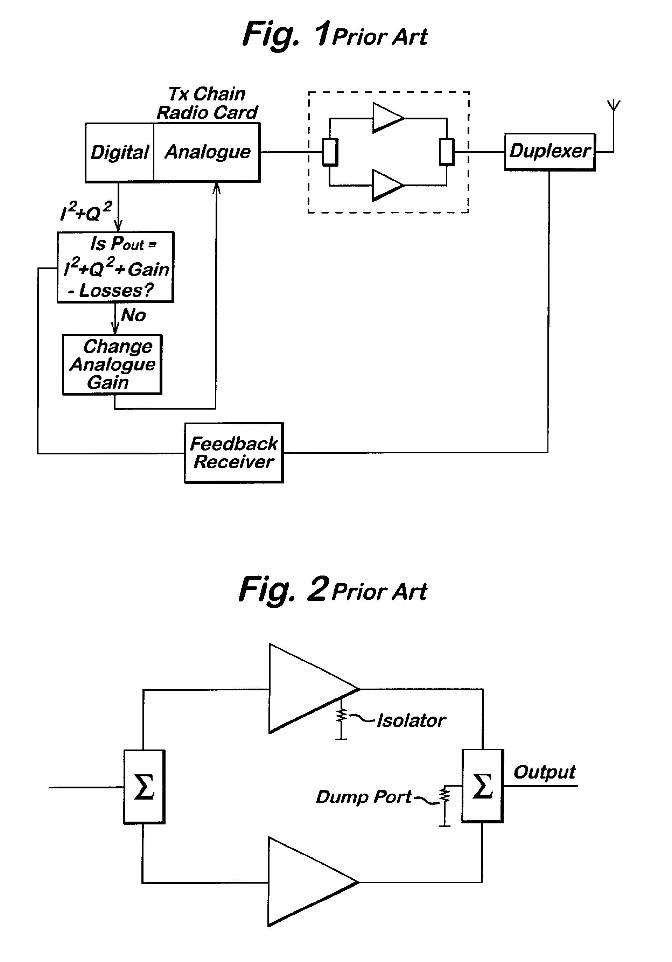

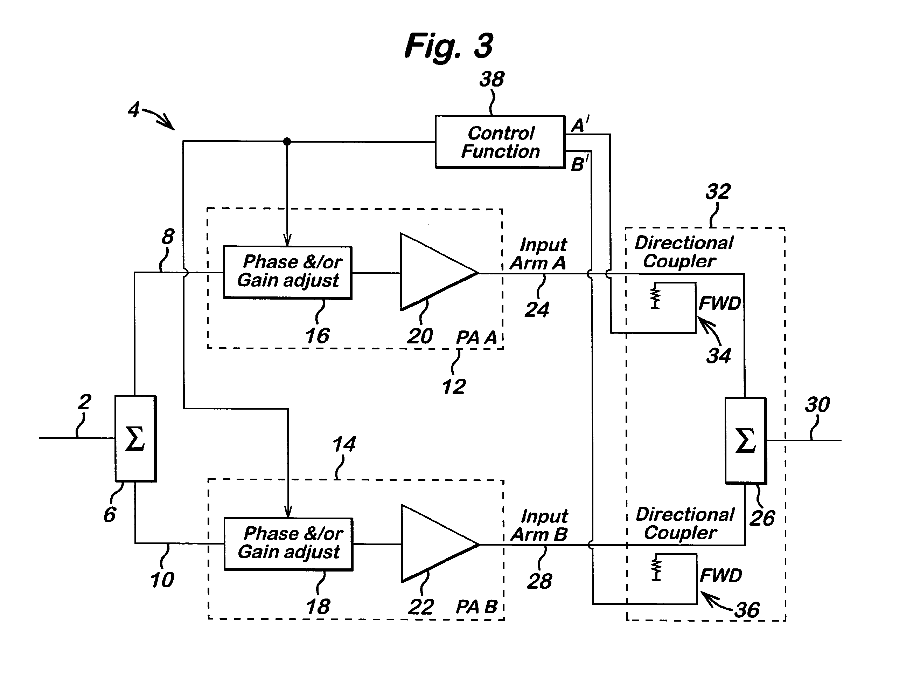

When a radio telecommunications base station for example needs to have its output power increased beyond its usual rating (e.g. to increase cell size), it is known for a parallel amplifier stage to be added to it, as shown in Figure 1. The known parallel amplifier stage includes a splitter before and a combiner after the two (or more) amplifiers as shown in more detail in Figure 2.

If all of the amplifiers in the parallel amplifier stage are ideal, that is exactly the same, then the combining and splitting process incurs no loss and the output power is doubled. In practice, the amplifiers are different. Even if built to very strict specifications, amplifiers differ, for example because they are different ages or from different suppliers.

The splitting and combining process occurring in the parallel amplifier stage is only lossless when the amplifiers are exactly the same. Even small differences cause significant losses to be incurred, and the RF output power will be lower than ideal multiplying-up of power, for example doubling of power when the parallel amplifier stage has two amplifiers. Dependent on the type of combining used any power that is lost is converted to heat in a dump port of the combiner connected to the amplifiers output ports, or reflected back to the amplifiers and converted to heat in dump ports of each amplifier, namely in isolators at the amplifiers' outputs. As is known, some combiners are four port networks having two input ports , an output port and an isolated port (dump port) via which the power difference between input signals at any instant is output.

It will thus be seen that known approaches to the use of parallel amplifiers involve the use of dump port(s) acting as a large heatsink to dissipate wasted heat. The amplifiers have to be larger and more expensive in consequence to overcome this waste. In a base station, circuitry including amplifiers is one of the most expensive parts, and the cost in power amplifiers alone is considerable. Any way of reducing power wastage thereby reducing the need to generate excess power to compensate is significant.

### Summary of the Invention

The present invention provides a circuit comprising at least two amplifiers electrically connected in parallel, including a controller operative to reduce the difference in amplitude between output signals from the amplifiers, the controller being operative to determine or receive an indicator of the difference in amplitude between the output signal of a first amplifier and the output signal of a second amplifier, and to adjust the gain of at least one of the first and second amplifiers dependent upon the indicator.

Preferably the controller determines the indicator by sampling the output signal of a first amplifier and the output signal of a second amplifier and comparing the sample signals. Preferably the controller receives the sample signals from respective directional couplers. Preferably the controller receives the sample signals from the directional couplers, one of which provided at each input port to the combiner , and furthermore preferably the directional couplers are provided in a combiner assembly. Alternatively preferably the controller receives the sample signals from the directional couplers, one of which is provided at the output port of each amplifier, and furthermore preferably each directional coupler is in an amplifier assembly.

Alternatively preferably the indicator is a measure of power dissipated. Preferably output ports of the amplifiers are connected by a combiner having multiple input ports, an output port and a dump port, the indicator being determined by the controller by measuring power output to the dump port. Alternatively preferably at least one amplifier has a circulator/isolator, the indicator being determined by the controller by detecting power dissipated in at least one of the circulator(s)/isolator(s). Preferably each amplifier has a circulator/isolator, the indicator being determined by the controller by combining the signals representative of power dissipated in each circulator/isolator.

Preferably the controller is also operative to reduce the difference in phase between output signals from the amplifiers, the controller being operative to determine or receive a further indicator, the further indicator being indicative of the difference in phase between the output signal of a first amplifier and the output signal of a second amplifier, and to adjust the phase of the input signal to at least one of the amplifiers dependent upon the further indicator.

The present invention also provides a radio telecommunications base station comprising the circuit. Furthermore the base station is preferably a Universal Mobile Telecommunications System base station.

The present invention also provides a method of reducing the difference in amplitude between output signals from amplifiers electrically connected in parallel by determining an indicator of the difference in amplitude between the output signal of a first amplifier and the output signal of a second amplifier, and adjusting the gain of at least one of the first and second amplifiers dependent upon the indicator.

Preferably the indicator is provided by sampling the output signal of a first amplifier and the output signal of a second amplifier and comparing the sample signals.

Alternatively preferably the indicator is a measure of power dissipated. Preferably output ports of the amplifiers are connected by a combiner having multiple input ports, an output port and a dump port, the indicator being determined by measuring power output to the dump port. Alternatively preferably at least one amplifier has a circulator/isolator, the indicator being determined by detecting power dissipated in at least one of the circulator/isolator(s). Preferably each amplifier has a circulator/isolator, the indicator being determined by combining the signals representative of power dissipated in each circulator/isolator.

Preferably reducing the difference in phase between the output signals from the amplifiers is also undertaken by determining a further indicator, the further indicator being indicative of the difference in phase between the output signal of a first amplifier and the output signal of a second amplifier, and adjusting the phase of the input signal to at least one of the amplifiers in dependence on the further indicator.

Preferred embodiments of the present invention thus can be considered as an intelligent RF power combiner. Advantages of preferred embodiments include that the power lost when combining two (or more) power amplifiers in parallel is reduced. The loss is reduced at the combined output of the parallel amplifiers. This in turn reduces the d.c. power needed to generate this RF power (typically 10% efficient), the cooling requirements of the system are reduced and the overall cost significantly reduced. By reducing the loss in the RF output power by just 0.5 dB, considerable savings can be made from the cost of a base station.

### Brief Description of the Drawings

Preferred embodiments of the present invention will now be described by way of example and with reference to the drawings, in which:
Figure 1 is a diagram illustrating a radio telecommunications base station (prior art),
Figure 2 is a diagram illustrating a known parallel amplifier stage (prior art),
Figure 3 is a diagram illustrating a parallel amplifier stage according to a first embodiment of the invention,
Figure 4 is a diagram illustrating a parallel amplifier stage according to a second embodiment of the invention,
Figure 5 is a diagram illustrating a parallel amplifier stage according to a third embodiment of the invention, and
Figure 6 is a diagram illustrating a parallel amplifier stage according to a fourth embodiment of the invention.

### Detailed Description

Systems are described involving gain, or gain and phase, adjustment, to keep amplifiers well matched during operation. Basically by using feedback from the combining network it is possible to tightly control the amplifier characteristics and reduce the loss in the combiner.

It can be shown that if the two (or more) parallel amplifiers are gain and phase aligned then the combining process will be almost lossless. Of the two, gain alignment is most significant factor. Tightly controlling the phase as occurs in some embodiments brings relatively small improvements in the power loss but does help in maintaining linearisation in amplifiers such as digital pre-distortion amplifiers and combined amplifiers.

There are various approaches to keeping the amplifier output signals aligned in gain (and optionally in phase also). These are considered below.

### Measurement of the difference in magnitude in each path.

In the circuit configuration shown in Figure 3, basically by measurement of the difference in magnitude in each path, a controller 38 alters the amplifier units 12,14 in order to achieve the minimum difference in gain, and hence the least power wasted due to losses in combiner 26 due to imbalances between signals A and B.

As shown in Figure 3 the input 2 to the parallel amplifier stage 4, is connected to a splitter 6 having two outputs 8,10. The first output 8 is provided to a first power amplifier unit 12,A and the second output 10 is provided to a second power amplifier unit 14, B. Each power amplifier unit 12,14 includes a phase and/or gain adjuster circuitry denoted 16, 18 respectively in addition to a power amplifier 20,22. The output from the first power amplifier unit 12 is provided on input arm A, 24 to a combiner 26 and the output from the second power amplifier unit 14 is provided on input arm B, 28 to a combiner 26. The combiner has an output 30.

The combiner 26 is part of a combiner unit 32 in which each input arm A,B that is arms 24,28 have an associated directional coupler denoted 34,36 respectively. The directional coupler 34 applied to arm A,24 provides a relatively low power signal A' proportional to the signal on arm A,24. The directional coupler 36 applied to arm B,28 provides a relatively low power signal B' proportional to the signal on arm B,28.

The two signals A', B' from the directional couplers 34,36 are provided to a controller 38 operative to compare the signals A', B' and send adjustment control signals to the power amplifier units 12,14. The controller 38 operates such that:
if A`=B`send signal to do nothing to gain.
if A'<B' send signal to increase gain of A relative to B,
if A'>B' send signal to increase gain of B relative to A.

In an alternative embodiment (not shown) difference in phase is also monitored and the control function operates to produce the minimum difference in phase also.

### Measurement of the magnitude of the output of each amplifier

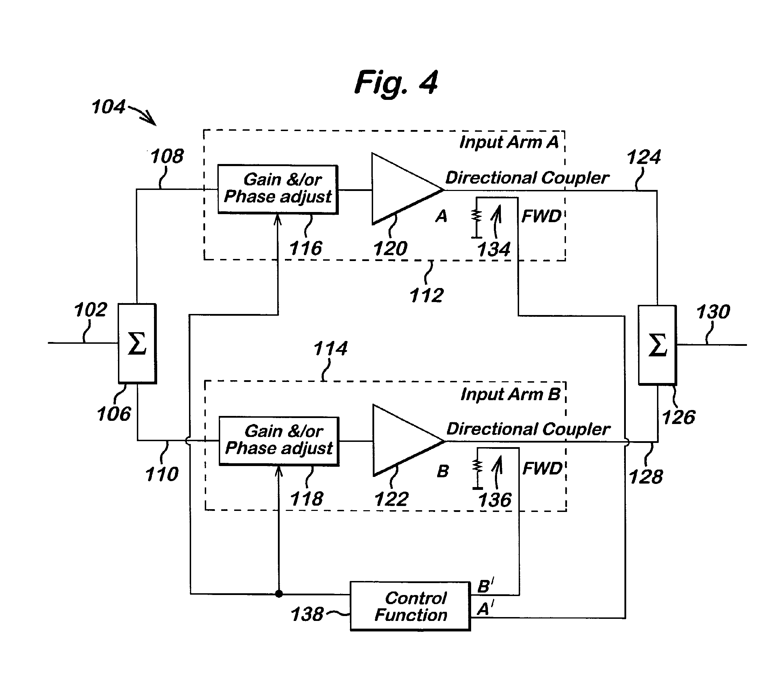

In the circuit configuration shown in Figure 4, measurement of the magnitude of the output of each amplifier is undertaken before the combining network. This information is fed back to the gain adjustment mechanism within each amplifier. Using the measured information the amplifier tunes its gain to the required levels.

The circuit configuration shown in Figure 4 is essentially the same as that shown in Figure 3 except that the directional couplers are shifted from a combiner unit to within the amplifier units.

As shown in Figure 4 the input 102 to the parallel amplifier stage 104, is connected to a splitter 106 having two outputs 108,110. The first output 108 is provided to a first power amplifier unit 112,A and the second output 110 is provided to a second power amplifier unit 114, B. Each power amplifier unit 112,114 includes a phase and/or gain adjuster circuitry denoted 116, 118 respectively in addition to a power amplifier 120,122. The output from the first power amplifier unit 112 is provided on input arm A, 124 to a combiner 126 and the output from the second power amplifier unit 114 is provided on input arm B, 128 to a combiner 126. The combiner has an output 130.

Within each amplifier unit 112, 114, each arm A,B that is arms 124,128 have an associated directional coupler denoted 134,136 respectively. The directional coupler 134 applied to arm A,124 provides a relatively low power signal A' proportional to the signal on arm A, 24. The directional coupler 136 applied to arm B,128 provides a relatively low power signal B' proportional to the signal on arm B, 128.

The two signals A', B' from the directional couplers 134,136 are provided to a controller 138 operative to compare the signals A', B' and send adjustment control signals to the power amplifier units 112,114. The controller 138 operates such that:
if A'=B' do nothing to gain.
if A'<B' send signal to increase gain of A relative to B,
if A'>B' send signal to increase gain of B relative to A.

In an alternative embodiment (not shown) phase of the output of each amplifier is also measured for phase adjustment within each amplifier.

### Monitoring of the power proportional to the difference between A and B

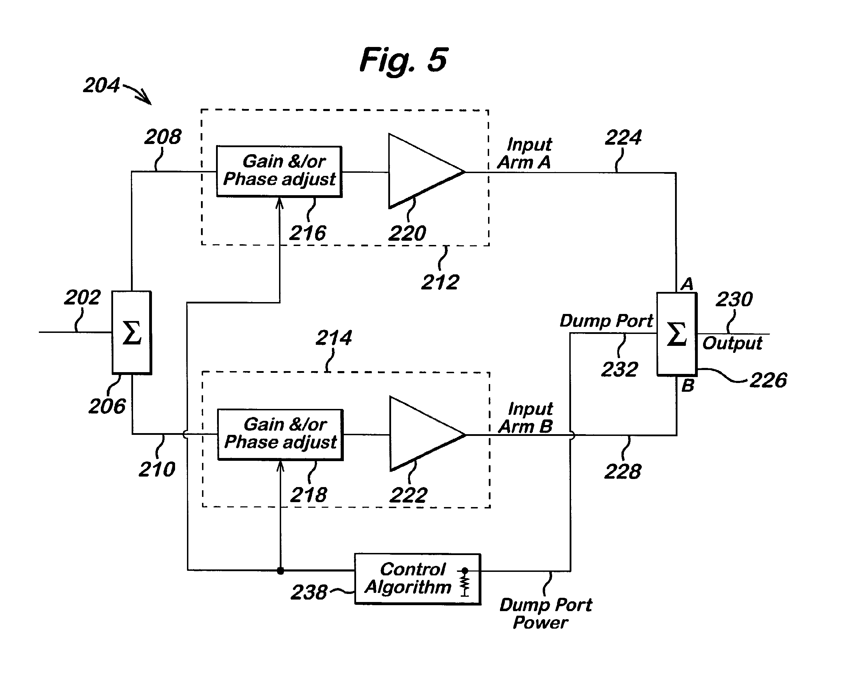

Using the configuration shown in Figure 5, monitoring is undertaken of the power proportional to the difference between A and B dissipated in a dump port of a combiner 226. This can be done using a number of methods, including having a temperature monitor or an RF power monitor within a controller. Using a controller it is possible to alter the gain and phases of each amplifier to minimise the power lost in the dump port of the combiner.

The circuit configuration shown in Figure 5 is essentially the same as that shown in Figure 3 and 4 except that rather than using directional couplers to sample amplified signals, a difference signal provided at a dump port of a combiner is used as a feedback signal instead.

As shown in Figure 5 the input 202 to the parallel amplifier stage 204, is connected to a splitter 206 having two outputs 208,210. The first output 208 is provided to a first power amplifier unit 212,A and the second output 210 is provided to a second power amplifier unit 214, B. Each power amplifier unit 212,214 includes a phase and/or gain adjuster circuitry denoted 216, 218 respectively in addition to a power amplifier 220,222. The output from the first power amplifier unit 212 is provided on input arm A, 224 to a combiner 226 and the output from the second power amplifier unit 214 is provided on input arm B, 228 to the combiner 226. The combiner has an output 230.

The combiner 226 has an output port 230 and an isolated port (dump port 232) via which the power difference between signals on input arms A,B at any instant is output. The power difference signal is provided to a controller 238 operative to send adjustment control signals to the power amplifier units 212,214 dependent on the power difference signal so as to minimise the power difference.

In a preferred embodiment a temperature sensor (not shown) is provided in the controller 238 to provide a signal having an amplitude dependent on dump port power. In an alternative embodiment, an RF power meter is provided in the controller instead for the same purpose. In further alternative embodiments, a temperature sensor or power meter is provided in the combiner.

### Monitor the power dissipated (related to the difference between A and B)

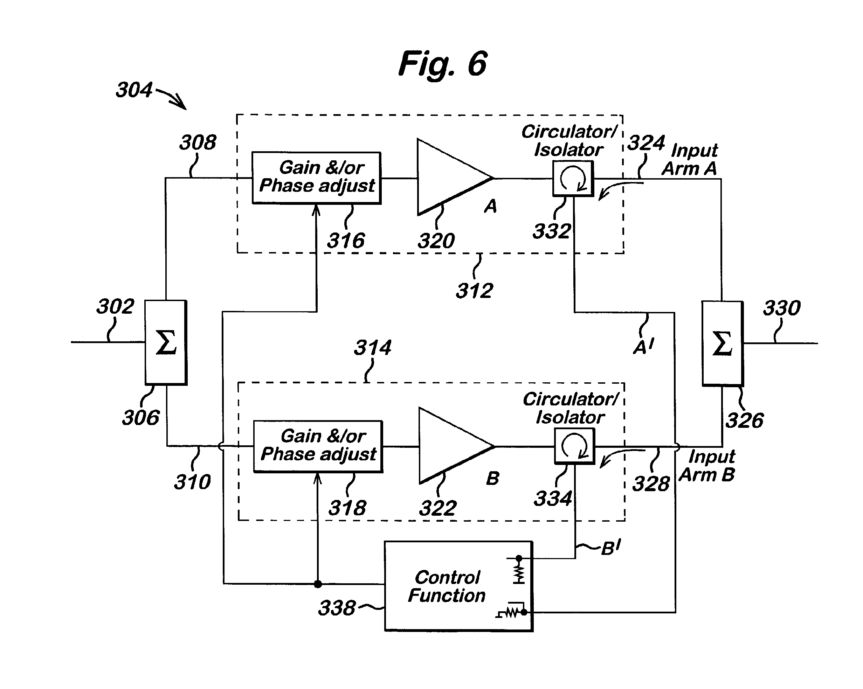

Using the configuration shown in Figure 6, the power dissipated (related to the difference between A and B)in the isolator dump ports of each amplifier is monitored and a control algorithm is used in [he controller to adjust the gain and phase of each amplifier to minimise dissipation. Reflected power due to impedance mismatches in the circuitry (mismatch uncertainty) mean this method is likely to be less accurate than the other methods proposed.

The circuit configuration shown in Figure 6 is essentially the same as that shown in Figure 3 and 4 except that rather than using directional couplers to sample amplified signals, power dissipated at dump ports of the amplifiers is monitored to provide a feedback signal instead. The circuit configuration shown in Figure 6 is essentially the same as that shown in Figure 5 except that rather than using a dump port of a combiner, the amplifier units are each provided with a dump port (circulator/ isolator) from which a signal representative of respective power dissipation is taken.

As shown in Figure 6 the input 302 to the parallel amplifier stage 304, is connected to a splitter 306 having two outputs 308,310. The first output 308 is provided to a first power amplifier unit 312,A and the second output 310 is provided to a second power amplifier unit 314, B. Each power amplifier unit 312,314 includes a phase and/or gain adjuster circuitry denoted 316,318 respectively in addition to a power amplifier 320,322. The output from the first power amplifier unit 312 is provided on input arm A, 324 to a combiner 326 and the output from the second power amplifier unit 314 is provided on input arm B, 328 to the combiner 326. The combiner has an output 330 but does not have a dump port.

Each amplifier unit 312,314 includes a circulator/isolator 332,334 connected between its respective amplifier 320,322 and its respective output arm (input arm A,B to combiner 326). The two circulator/isolators 332,334 act as dump ports providing signals A', B' related to power reflected from combiner input ports 324, 328 due to power imbalance at the combiner 326. The signals A',B' are provided to a controller 338 operative to send adjustment control signals to the power amplifier units 212,214 dependent on the signals A',B' it receives, so as to reduce waste power dissipation.

## Claims

1. A circuit comprising at least two amplifiers (20,22,120,122,220,222,320,322) electrically connected in parallel, including a controller (38,138,238,338) operative to reduce the difference in amplitude between output signals from the amplifiers. the controller (38,138,238,338) being operative to determine or receive an indicator of the difference in amplitude between the output signal (A) of a first amplifier (20,120,220,320) and the output signal (B) of a second amplifier (22,122,222,322), and to adjust the gain of at least one of the first and second amplifiers dependent upon the indicator.

2. A circuit according to claim 1, in which the controller (38,138) determines the indicator by sampling the output signal (A) of a first amplifier (20,120) and the output signal (B) of a second amplifier (22,122) and comparing (38,138) the sample signals.(A',B').

3. A circuit according to claim 2, in which the controller (38,138) receives the sample signals (A',B') from respective directional couplers (34,36, 134,136).

4. A circuit according to claim 1. in which the indicator is a measure of power dissipated.

5. A circuit according to claim 4, in which output ports (224,228)of the amplifiers (220,222) are connected by a combiner having multiple input ports, an output port (230)and a dump port (232), the indicator being determined by the controller (238) by measuring power output to the dump port (232).

6. A circuit according to claim 4, in which at least one amplifier (320,322) has a circulator/isolator (332,334) the indicator being determined by the controller (338) by detecting power dissipated in at least one of the circulator(s)/isolator(s) (332,334).

7. A circuit according to claim 6, in which each amplifier (320,322) has a circulator/isolator (332,334), the indicator being determined by the controller (338) by combining the signals representative of power dissipated in each circulator/isolator (332,334).

8. A circuit according to any of claims 1 to 7, in which the controller (38,138,238,338) is also operative to reduce the difference in phase between output signals from the amplifiers, the controller (38,138,238,338) being operative to determine or receive a further indicator, the further indicator being indicative of the difference in phase between the output signal (A) of a first amplifier (20,120,220,320) and the output signal (B) of a second amplifier (22,122.222,322), and to adjust the phase of the input signal to at least one of the first and second amplifiers dependent upon the further indicator.

9. A radio telecommunications base station comprising the circuit according to any of claims 1 to 8.

10. A method of reducing the difference in amplitude between output signals from amplifiers electrically connected in parallel by determining an indicator of the difference in amplitude between the output signal (A) of a first amplifier (20,120,220,320) and the output signal (B) of a second amplifier (22,122,222,322), and adjusting the gain of at least one of the first and second amplifiers dependent upon the indicator.
